# EUROPEAN PATENT APPLICATION

(11) **EP 4 759 964 A1**
(43) Date of publication of application: **17.06.2026**
(21) Application number: 24850790.7
(22) Date of filing: 23.07.2024
(51) Int. Cl.: C23C 16/455

(54) **SPRAY PLATE, SPRAY METHOD AND TREATMENT DEVICE**

(30) Priority: 07.08.2023 CN 202310981606
(71) Applicant: Jiangsu Leadmicro Nano-Technology Co., Ltd., Wuxi, Jiangsu 214000 (CN)
(72) Inventor: SHI, Shupeng, Wuxi, Jiangsu 214000 (CN); YAN, Da, Wuxi, Jiangsu 214000 (CN)
(74) Representative: van Breda, Jacobus
(86) International application number: PCT/CN2024/107027
(87) International publication number: WO 2025/031141

(57) **Abstract**

A spray plate, a spray method and a treatment device. The spray plate comprises a plate body having a gas outlet face, the plate body thereof being internally provided with at least two spray flow channel groups, and the at least two spray flow channel groups being successively arranged within a spray surface of the spray plate; each spray flow channel group comprises at least two process gas flow channels, the at least two process gas flow channels being offset with respect to each other in the thickness direction of the plate body; each process gas flow channel comprises a main gas channel, a plurality of spray gas channels and a plurality of gas outlet holes, the main gas channel being separately communicated with the plurality of spray gas channels, the plurality of gas outlet holes being arranged at intervals in the spray gas channels, and all of the plurality of gas outlet holes being arranged in the gas outlet face of the plate body. The present solution can partition the spray surface into multiple regions so as to effectively shorten the length of the flow channels and accordingly reduce the pressure drop, such that the amount of gas discharged from the gas outlet holes in the same flow path is reasonably controlled, thus effectively improving the gas outlet uniformity of the spray plate.

## Description

The present application claims priority to Chinese Patent Application No. 202310981606.7, titled "SPRAY PLATE, SPRAY METHOD AND TREATMENT DEVICE", filed with the China National Intellectual Property Administration on August 7, 2023, which is incorporated herein by reference in its entirety.

### FIELD

The present application relates to the technical field of vacuum coating, and in particular to a spray plate, a spray method, and a treatment device.

### BACKGROUND

During industrial production processes, a specific process gas usually needs to be sprayed into a reaction chamber of a treatment device through a spray plate to promote a corresponding reaction. For example, but not limited to, atomic layer deposition (ALD) technology is a thin film deposition technology based on a surface chemical vapor reaction. With this technology, a surface of a substrate is coated with a material in the form of a monoatomic layer film, and the thickness and uniformity of the deposited thin film can be precisely controlled within the range of thickness of the atomic layers. To ensure uniformity of film formation, the process gas needs to be introduced into the reaction chamber by the spray plate firstly for a coating reaction.

The existing gas uniformization structure used for atomic layer deposition is a spray plate. In the specific practice, an external gas source is introduced into the interior of the spray plate, and the process gas is uniformly blown into the reaction chamber through flow channels and discharge holes integrated to the spray plate. Such spray plate structure has a gas source port on each side of the spray plate. Two types of process gases are introduced into the spray plate through longitudinal flow channels located on both sides, respectively, and then flow towards opposite sides through multiple transverse flow channels in communication with the corresponding longitudinal flow channels, respectively, and then are sequentially sprayed through the discharge holes on the transverse flow channels. When the process gas is flowing through the transverse flow channels, the gas pressure gradually decreases due to flow resistance along each flow path, and thus the flow velocity of the gas sprayed from each discharge hole in the transverse flow channels decreases progressively, resulting in non-uniform gas concentration within the reaction chamber.

Especially, with the increase of equipment production capacity, the sizes of the reaction chamber and the spray plate also increase, resulting in a significant difference in the concentration of the process gas at both ends of the transverse flow channel, which seriously affects uniformity of gas discharge and deteriorates uniformity of film deposition, leading to poor product yield.

In view of this, it is required to optimize the spray plate structure to overcome the above-mentioned defects.

### SUMMARY

An object of the present application is to provide a spray plate, a spray method, and a treatment device, which can improve the uniformity of gas discharge from the spray plate through structural optimization of the spray plate.

A spray plate according to an embodiment of the present application includes a body that has a gas discharge surface. At least two spray flow channel groups are provided in the body, which are sequentially arranged within a spray area of the spray plate. Each spray flow channel group includes at least two process gas flow channels, which are arranged in an offset manner in a thickness direction of the body. Each process gas flow channel includes a main gas channel and multiple spray gas channels. The main gas channel is in communication with each spray gas channel, and the spray gas channel is provided with multiple gas discharge holes that are arranged at intervals. The multiple gas discharge holes are all formed in the gas discharge surface of the body.

In an embodiment, each spray flow channel group includes two process gas flow channels, which are a first process gas flow channel and a second process gas flow channel. The first process gas flow channel includes a first main gas channel and multiple first spray gas channels. The first main gas channel is in communication with each first spray gas channel, and the first spray gas channel is provided with multiple first gas discharge holes that are sequentially arranged at intervals. The second process gas flow channel includes a second main gas channel and multiple second spray gas channels. The second main gas channel is in communication with each second spray gas channel, and the second spray gas channel is provided with multiple second gas discharge holes that are sequentially arranged at intervals.

In an embodiment, within the spray area, each of the multiple first spray gas channels and the multiple second spray gas channels extends in a first direction, and each of the first main gas channel and the second main gas channel extends in a second direction. The first direction is different from the second direction.

In an embodiment, the multiple first spray gas channels and the multiple second spray gas channels are arranged in an alternate manner at intervals in the second direction.

In an embodiment, the multiple first spray gas channels and the multiple second spray gas channels are arranged in the alternate manner at equal intervals in the second direction.

In an embodiment, the first main gas channel includes two first main gas channels which are respectively located at both ends of the multiple first spray gas channels and are in communication with each first spray gas channel. The second main gas channel includes two second main gas channels which are respectively located at both ends of the multiple second spray gas channels and are in communication with each second spray gas channel.

In an embodiment, the spray flow channel group includes two first gas inlet ports, two first gas inlet channels, two second gas inlet ports, and two first gas inlet channels. The two first gas inlet ports are respectively located at both ends of the two first main gas channels in the second direction. One of the two first gas inlet ports located at one end of the two first main gas channels is in communication with one end of each first main gas channel through one of the two first gas inlet channels, and the other one of the two first gas inlet ports located at the other end of the two first main gas channels is in communication with the other end of each first main gas channel through the other one of the two first gas inlet channels. The two second gas inlet ports are respectively located at both ends of the two second main gas channels in the second direction. One of the two second gas inlet ports located at one end of the two second main gas channels is in communication with one end of each second main gas channel through one of the two second gas inlet channels, and the other one of the two second gas inlet ports located at the other end of the two second main gas channels is in communication with the other end of each second main gas channel through the other one of the two second gas inlet channels.

In an embodiment, the spray flow channel groups include multiple spray flow channel groups, which are sequentially arranged in a linear manner within the spray area.

In an embodiment, the spray flow channel groups include multiple spray flow channel groups, which are sequentially arranged in a matrix manner within the spray area.

In an embodiment, the body of the spray plate is formed by connecting at least two sub plates, and at least one spray flow channel group is provided in a body of each sub plate.

A treatment device is further provided according to the present application, including the spray plate as described above and a processing chamber. The spray plate is disposed on the processing chamber, and the gas discharge surface of the spray plate is oriented towards an inner side of the processing chamber.

A spray method implemented by the treatment device as described above is further provided according to the present application, including: introducing a process gas into the main gas channel through a gas inlet port and a gas inlet channel of each spray flow channel group; introducing the process gas through the main gas channel into the spray gas channels in communication with the main gas channel; and conveying the process gas, which is introduced into the spray gas channels, along the spray gas channels and spraying it into the processing chamber through the gas discharge holes arranged along the spray gas channels.

Compared with the related art, the configuration of the spray flow channel groups within the spray area is optimized in the present application. Specifically, at least two spray flow channel groups are provided within the spray area of the spray plate, dividing the spray area into multiple zones, which effectively shortens the flow channels and thus reduces pressure drop in the flow path. This allows for reasonable control of the amount of sprayed gas from each gas discharge hole in the same flow path, thereby effectively improving the uniformity of gas discharge from the spray plate. These technological advantages are particularly significant for large-sized spray plates.

### BRIEF DESCRIPTION OF THE DRAWINGS

FIG. 1 is a schematic structural view of a spray plate according to an embodiment of the present application;
FIG. 2 is a view in the direction of arrow A in FIG. 1;
FIG. 3 is a schematic structural view of a spray plate according to another embodiment of the present application;
FIG. 4 is a schematic structural view of a spray plate according to yet another embodiment of the present application;
FIG. 5 is a schematic structural view of a treatment device according to an embodiment of the present application; and
FIG. 6 is a schematic flowchart showing a spray method according to an embodiment of the present application.

Reference numerals in the figures are listed as follows:
100. spray plate;
200. processing chamber;
10. spray flow channel group;
11. first main gas channel;
12. first spray gas channel;
13. first gas discharge hole;
14. first gas inlet port;
15. first gas inlet channel;
21. second main gas channel;
22. second spray gas channel;
23. second gas discharge hole;
24. second gas inlet port;
25. second gas inlet channel.

### DETAILED DESCRIPTION OF THE EMBODIMENTS

In order to better understand technical solutions of the present application by those skilled in the art, a further detailed explanation of the present application is made below in conjunction with the accompanying drawings and specific embodiments.

Without loss of generality, the embodiments herein primarily focus on spraying of two process gases and detail implementations for improving uniformity of gas discharge. It should be understood that the number of spray gases and the type of gas sources may be configured according to reaction functions and requirements of actual application scenarios, and do not constitute substantive limitations on the claimed technical solutions of the present application.

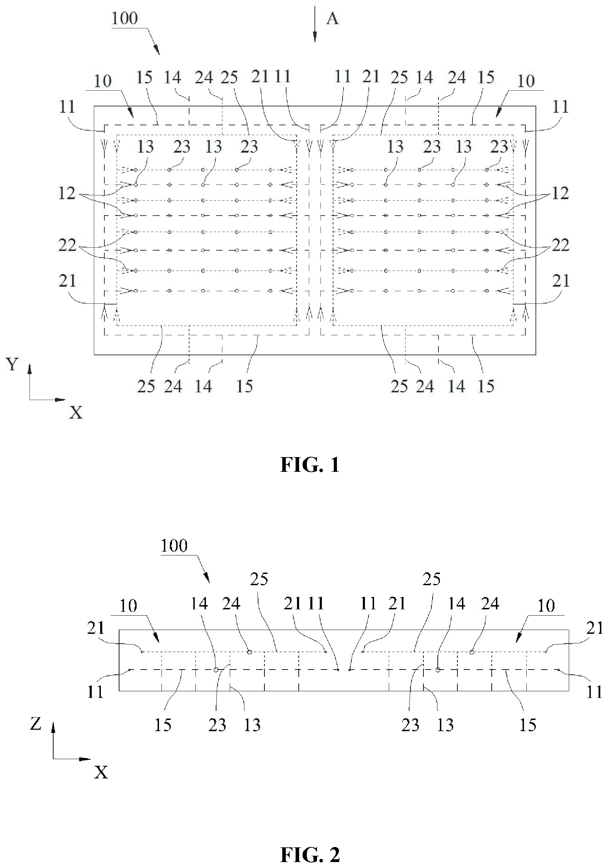

Reference is made to FIG. 1, which is a schematic structural view of a spray plate according to an embodiment of the present application.

As shown, two spray flow channel groups 10 are provided in a body of the spray plate 100. The two spray flow channel groups 10 are sequentially arranged within a spray area of the spray plate 100. Here, the "spray area" refers to an extension surface encompassing spray zones covered by all gas discharge holes of the spray plate 100.

In this embodiment, each spray flow channel group 10 includes a first main gas channel 11, multiple first spray gas channels 12, first gas discharge holes 13, a second main gas channel 21, multiple second spray gas channels 22, and second gas discharge holes 23. The first main gas channel 11, the multiple first spray gas channels 12, and the first gas discharge holes 13 form a first process gas flow channel, and the second main gas channel 21, the multiple second spray gas channels 22, and the second gas discharge holes 23 form a second process gas flow channel. The first gas discharge holes 13 and the second gas discharge holes 23 are formed on a gas discharge surface of the spray plate 100 to uniformly spray the two process gases, respectively.

As such, each spray flow channel group 10 can spray the first process gas through the first gas discharge holes 13 and spray the second process gas through the second gas discharge holes 23. For example, for the atomic layer deposition process, the first process gas and the second process gas may be two process reaction precursors used to form coating products.

In other implementations, the number of spray flow channel groups 10 may be determined based on actual application scenarios and the size of the spray plate, rather than being limited to the two spray flow channel groups 10 as shown in FIG. 1. For example, but not limited to, the number of spray flow channel groups 10 may be three or more.

Generally, based on arrangement of multiple spray flow channel groups 10, the spray area of the spray plate 100 is divided into multiple zones, effectively shortening the flow channels and thus reducing pressure drop in each flow path. This allows for reasonable control of the amount of sprayed gas from each gas discharge hole in the same flow path, thereby effectively improving the uniformity of gas discharge from the spray plate. These technological advantages are particularly significant for large-sized spray plates.

Further, based on the arrangement of the multiple spray flow channel groups 10, the gas flow rate can be independently controlled as needed in practical applications to achieve a zone-specific control within the spray area, further improving the uniformity of the sprayed gas.

For ease of description, within the spray area of the spray plate 100, an extension direction of the first spray gas channel 12 and the second spray gas channel 22 is defined as a first direction, and an extension direction of the first main gas channel 11 and the second main gas channel 21 is defined as a second direction. In addition, a thickness direction of the spray plate 100 is defined as a third direction.

As shown in FIG. 1, the first direction X and the second direction Y, which are substantially perpendicular to each other, are taken as examples for illustration. In other implementations, the first direction X and the second direction Y may also be two different directions intersecting at other angles to properly distribute the process gas from the main gas channel to the corresponding spray gas channels within the spray area, which is not limited in the embodiments of the present application.

The multiple first spray gas channels 12 and the multiple second spray gas channels 22 extend in the first direction X. Within the spray area of the spray plate 100, the first spray gas channels 12 and the second spray gas channels 22 are arranged in an alternate manner at intervals in the second direction Y, that is, in the second direction Y, the first spray gas channels 12 and the second spray gas channels 22 are arranged in a sequentially adjacent manner, so as to improve mixing of the two process gases.

In an implementation, within the spray area, the first spray gas channels 12 and the second spray gas channels 22 may be arranged in the alternate manner at equal intervals in the second direction Y, which can further improve mixing uniformity of the two process gases.

The first main gas channel 11 and the second main gas channel 21 extend in the second direction Y. The first main gas channel 11 is in communication with the multiple corresponding first spray gas channels 12, and each first spray gas channel 12 is provided with multiple first gas discharge holes 13 sequentially arranged at intervals for spraying the first process gas. The second main gas channel 21 is in communication with multiple corresponding second spray gas channels 22, and each second spray gas channel 22 is provided with multiple second gas discharge holes 23 sequentially arranged at intervals for spraying the second process gas.

To further shorten the flow channels, each spray flow channel group 10 have two first main gas channels 11 and two second main gas channels 21 located at both ends of the corresponding spray gas channels, respectively. Specifically, the two first main gas channels 11 are respectively located at both ends of the multiple first spray gas channels 12 and are in communication with each first spray gas channel 12. The two second main gas channels 21 are respectively located at both ends of the multiple second spray gas channels 22 and are in communication with each second spray gas channel 22. In this way, the flow path of the process gas in the spray gas channel can be shortened, further reducing impact of flow resistance on the uniformity of gas discharge.

In an implementation, the multiple first gas discharge holes 13 are arranged in each first spray gas channel 12 at equal intervals, and the multiple second gas discharge holes 23 are arranged in each second spray gas channel 22 at equal intervals, which improve the uniformity of gas discharge within the spray area.

It should be noted that the first spray gas channels 12 and the second spray gas channels 22 that extend in the first direction X, as well as the first main gas channels 11 and the second main gas channels 21 that extend in the second direction Y, may be arranged as linear gas channels extending in a linear manner as shown in the figure or non-linear gas channels (for example, but not limited to, gas channels having regular or irregular waveforms) with an extension trend in the shown direction, which is not limited in the embodiments of the present application.

Reference is made to FIG. 2, which is a view in the direction of arrow A in FIG. 1. In the third direction Z, the first process gas flow channel and the second process gas flow channel are arranged in an offset manner, so that these two flow channels are not in communication with each other, which can prevent different process gases from mixing and reacting in the flow channels, thereby avoiding dust formation and subsequent blockage. In other words, each spray flow channel group 10 has a first process gas flow channel and a second process gas flow channel arranged at different levels in the thickness direction of the spray plate 100, so as to avoid interference with each other and achieve a simple and reasonable structure, where the first process gas flow channel is formed by two first main gas channels 11, multiple first spray gas channels 12, and first gas discharge holes 13, and the second process gas flow channel is formed by two second main gas channels 21, multiple second spray gas channels 22, and second gas discharge holes 23.

Furthermore, for each spray flow channel group 10, the first gas inlet port 14 and the second gas inlet port 24 are arranged at each of two ends of the spray plate 100 in the second direction Y, which can further shorten the flow channels. By such arrangement, on the one hand, the process gas that meets the flow requirements can be supplied within the corresponding spray area, and on the other hand, the flow resistance of the process gas in the flow path of the corresponding main flow channel can be properly controlled, which can further improves the uniformity of gas discharge.

The first gas inlet port 14 is used to introduce the first process gas. For the two ends of the spray plate 100 in the second direction Y, the first gas inlet port 14 located at one end is in communication with one end of each of the two first main gas channels 11 through one first gas inlet channel 15, and the first gas inlet port 14 located at the other end is in communication with the other end of each of the two first main gas channels 11 through another first gas inlet channel 15. The first process gas is introduced through both ends of each of the two first main gas channels 11.

The second gas inlet port 24 is used to introduce the second process gas. For the two ends of the spray plate 100 in the second direction Y, the second gas inlet port 24 located at one end is in communication with one end of each of the two second main gas channel 21 through one second gas inlet channel 25, and the second gas inlet port 24 located at the other end is in communication with the other end of each of the two second main gas channel 21 through another second gas inlet channel 25. The second process gas is introduced through both ends of each of the two second main gas channel 21.

Generally, each process gas is introduced into the spray plate 100 through the gas inlet ports (first gas inlet port 14 and second gas inlet port 24) shown on upper and lower sides, respectively, and is diverted to both sides through the corresponding gas inlet channels (first gas inlet channel 15 and second gas inlet channel 25). After passing through the two main gas channels (first main gas channel 11 and second main gas channel 21) on the both sides, respectively, the process gas flows towards the center through the respective spray flow channels (first spray gas channel 12 and second spray gas channel 22). Here, the flow resistance of the spray flow channel can be equivalent to 1/4 of that in the conventional spray plate structure. By such arrangement, the flow channels for the two process gases are shorten and relatively symmetrically arranged, which can effectively reduce flow resistance and improve the uniformity of gas discharge.

In other implementations, each spray flow channel group 10 may be configured with only one first gas inlet port 14 and one second gas inlet port 24 (not shown in the figures). Of course, this configuration is more suitable for relatively small-sized spray plates.

Furthermore, to ensure the working flow rate of each spray gas channel arranged in the first direction, for different process gas flow channels, the gas inlet channel and the main gas channel each are larger in flow cross-section than the corresponding spray gas channel. That is, the first gas inlet channel 15 and the first main gas channel 11 each are larger in flow cross-section than the first spray gas channel 12, and the second gas inlet channel 25 and the second main gas channel 21 each are larger in flow cross-section than the second spray gas channel 22.

In addition to application scenarios for the two process gases, based on the spray plate described in the above embodiments, a spray plate that can be applied for three or more process gases may be further provided. In an implementation, taking three process gases as an example, a third process gas flow channel (not shown in the figures) is added in each spray flow channel group. Similarly, the third process gas flow channel is formed by a gas inlet port, a gas inlet channel, a main gas channel, a spray gas channel, and a corresponding gas discharge hole. In the third direction Z, the first process gas flow channel, the second process gas flow channel, and the third process gas flow channel are arranged in an offset manner, so that the three flow channels are not in communication with each other.

It can be understood that specific components of the third process gas flow channel and its relative position in the spray plate with respect to the first process gas flow channel and the second process gas flow channel are the same as the configuration of the first process gas flow channel and the second process gas flow channel, which will not be repeated here.

In addition, for the spray plate that has three or more spray flow channel groups 10, the respective spray flow channel groups 10 may be sequentially arranged in a linear manner or in a matrix manner within the spray area.

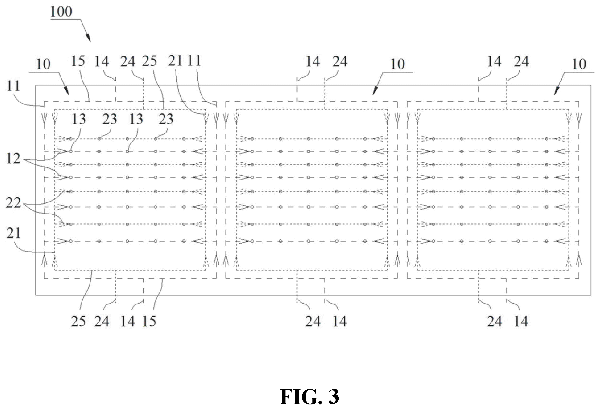

Reference is made to FIG. 3, which is a schematic structural view of a spray plate according to another embodiment of the present application. To clearly illustrate the differences and connections between this embodiment and the embodiment described in FIG. 1, components or structures having the same function are represented by the same reference numerals in the figure.

As shown in FIG. 3, the spray plate 100 includes three spray flow channel groups 10 in its body. The three spray flow channel groups 10 are sequentially arranged in a linear manner within the spray area of the spray plate 100. For the spray plate 100 described in this embodiment, specific components of the respective spray flow channel groups 10 and their relative positions in the plate are the same with the embodiment in FIG. 1, which will not be repeated here.

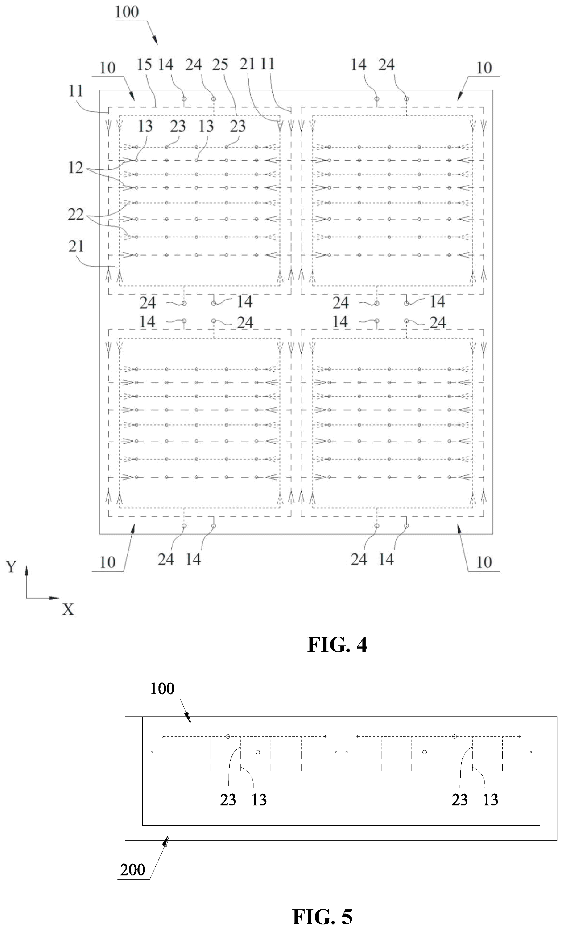

Reference is made to FIG. 4, which is a schematic structural view of a spray plate according to yet another embodiment of the present application. To clearly illustrate the differences and connections between this embodiment and the embodiment described in FIG. 1, components or structures having the same function are represented by the same reference numerals in the figure.

As shown in FIG. 4, the spray plate 100 includes four spray flow channel groups 10 in its body. The four spray flow channel groups 10 are sequentially arranged in a matrix manner within the spray area of the spray plate 100. That is, two spray flow channel groups 10 are sequentially arranged in each row and each column. Of course, for other numbers of spray flow channel groups 10, the specific numbers of rows and columns may be determined based on the overall product design.

In an implementation, the first gas inlet port 14 and the second gas inlet port 24 of each spray flow channel group 10 may be formed on an opposite side plate surface of the spray plate 100 relative to the gas discharge surface, simplifying the manufacturing process and facilitating connection to external gas source pipelines.

For the spray plate 100 described in this embodiment, other specific components of the respective spray flow channel groups 10 and the their relative positions in the plate are the same with the embodiment in FIG. 1, which will not be repeated here.

Further, for the spray plates described in the above embodiments, multiple spray flow channel groups are sequentially arranged in the body of the spray plate to effectively shorten the flow channels. In other implementations, the body of the spray plate is formed by connecting multiple sub plates. Accordingly, one or more spray flow channel groups may be provided in the body of each sub plate (not shown in the figures).

Specifically, the sub plates are coupled to form a spray plate in a manner that may be determined according to actual product requirements, for example, but not limited to, the sub plates are connected sequentially in a linear manner or in a matrix manner.

The spray flow channel groups provided on the coupled sub plates are sequentially arranged within the spray area of the spray plate. Compared with the above embodiment in which multiple spray flow channel groups are arranged in the body of one single plate, connecting multiple sub plates to form the spray plate can properly control the manufacturing process and processing cost, and can facilitate maintenance and repair. Further, for the case where the body of the spray plate is formed by connecting multiple sub plates, each sub plate may have the same structural dimension so as to improve interchangeability and thus further reduce manufacturing and maintenance cost.

In addition to the spray plates as described above, a treatment device is further provided according to an embodiment of the present application, as shown in FIG. 5, which is a schematic structural view of a treatment device according to an embodiment of the present application.

The treatment device includes a spray plate 100 and a processing chamber 200. The spray plate 100 is disposed on the processing chamber 200, and the spray plate 100 may be any of the spray plates as described in FIGS. 1 to 4. The gas discharge surface of the spray plate 100 is oriented towards an inner side of the processing chamber 200. The process gas is introduced into the spray plate 100 and can be sprayed into the processing chamber 200 through the first gas discharge holes 13 and the second gas discharge holes 23 in the gas discharge surface of the spray plate 100.

It should be understood that the processing chamber and other functional components of the treatment device may be obtained based on the existing process technology, which will not be repeated here.

A spray method is further provided according to an embodiment of the present application, which may use the spray plate as described in any one of the embodiments. It should be noted that the spray method in this embodiment has all technical effects of the above spray plate and can address the corresponding technical issues, which will not be repeated here.

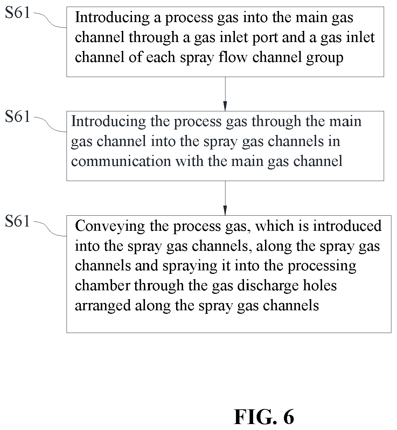

Reference is made to FIG. 6, which is a schematic flowchart showing a spray method according to an embodiment of the present application.

The spray method includes following steps:

Step S61, introducing a process gas into the main gas channel through a gas inlet port and a gas inlet channel of each spray flow channel group;

Step S62, introducing the process gas through the main gas channel into the spray gas channels in communication with the main gas channel; and

Step S63, conveying the process gas, which is introduced into the spray gas channels, along the spray gas channels and spraying it into the processing chamber through the gas discharge holes arranged along the spray gas channels.

The ordinal terms "first" and "second" used herein are only used to describe the components or structures having the same function in the technical solutions. It can be understood that the use of such ordinal terms "first" and "second" should not be regarded as a limitation on the understanding of the claimed technical solution in the present application.

Only preferred embodiments of the present application are described above. It should be noted that several improvements and modifications can be made by those skilled in the art, without departing from the principles of the present application. These improvements and modifications should be regarded as falling within the protection scope of the present application.

## Claims

1. A spray plate, comprising a body that has a gas discharge surface, wherein at least two spray flow channel groups are provided in the body, and are sequentially arranged within a spray area of the spray plate;
wherein each spray flow channel group comprises at least two process gas flow channels, which are arranged in an offset manner in a thickness direction of the body; and
wherein each process gas flow channel comprises a main gas channel and a plurality of spray gas channels, wherein the main gas channel is in communication with each spray gas channel, and the spray gas channel is provided with a plurality of gas discharge holes that are arranged at intervals, wherein the plurality of gas discharge holes are all formed in the gas discharge surface of the body.

2. The spray plate according to claim 1, wherein each spray flow channel group comprises two process gas flow channels, which are a first process gas flow channel and a second process gas flow channel;
the first process gas flow channel comprises a first main gas channel and a plurality of first spray gas channels, wherein the first main gas channel is in communication with each first spray gas channel, and the first spray gas channel is provided with a plurality of first gas discharge holes that are sequentially arranged at intervals; and
the second process gas flow channel comprises a second main gas channel and a plurality of second spray gas channels, wherein the second main gas channel is in communication with each second spray gas channel, and the second spray gas channel is provided with a plurality of second gas discharge holes that are sequentially arranged at intervals.

3. The spray plate according to claim 2, wherein within the spray area, each of the plurality of first spray gas channels and the plurality of second spray gas channels extends in a first direction, and each of the first main gas channel and the second main gas channel extends in a second direction; and
the first direction is different from the second direction.

4. The spray plate according to claim 3, wherein the plurality of first spray gas channels and the plurality of second spray gas channels are arranged in an alternate manner at intervals in the second direction.

5. The spray plate according to claim 4, wherein the plurality of first spray gas channels and the plurality of second spray gas channels are arranged in the alternate manner at equal intervals in the second direction.

6. The spray plate according to any one of claims 3 to 5, wherein the first process gas flow channel comprises two first main gas channels, which are respectively located at both ends of the plurality of first spray gas channels and are in communication with each first spray gas channel; and
the second process gas flow channel comprises two second main gas channels, which are respectively located at both ends of the plurality of second spray gas channels and are in communication with each second spray gas channel.

7. The spray plate according to claim 6, wherein the spray flow channel group comprises two first gas inlet ports, two first gas inlet channels, two second gas inlet ports, and two second gas inlet channels;
the two first gas inlet ports are respectively located at both ends of the two first main gas channels in the second direction, wherein one of the two first gas inlet ports located on one end of the two first main gas channels is in communication with one end of each first main gas channel through one of the two first gas inlet channels, and the other one of the two first gas inlet ports located at the other end of the two first main gas channels is in communication with the other end of each first main gas channel through the other one of the two first gas inlet channels; and
the two second gas inlet ports are respectively located at both ends of the two second main gas channels in the second direction, wherein one of the two second gas inlet ports located at one end of the two second main gas channels is in communication with one end of each second main gas channel through one of the two second gas inlet channels, and the other one of the two second gas inlet ports located at the other end of the two second main gas channels is in communication with the other end of each second main gas channel through the other one of the two second gas inlet channels.

8. The spray plate according to claim 1, wherein the spray flow channel groups comprise a plurality of spray flow channel groups, which are sequentially arranged in a linear manner within the spray area.

9. The spray plate according to claim 1, wherein the spray flow channel groups comprise a plurality of spray flow channel groups, which are sequentially arranged in a matrix manner within the spray area.

10. The spray plate according to claim 1, wherein the body of the spray plate is formed by connecting at least two sub plates, and at least one spray flow channel group is provided in a body of each sub plate.

11. A treatment device, comprising the spray plate according to any one of claims 1 to 10 and a processing chamber, wherein the spray plate is disposed on the processing chamber, and the gas discharge surface of the spray plate is oriented towards an inner side of the processing chamber.

12. A spray method implemented by the treatment device according to claim 11, comprising:
introducing a process gas into the main gas channel through a gas inlet port and a gas inlet channel of each spray flow channel group;
introducing the process gas through the main gas channel into the spray gas channels in communication with the main gas channel; and
conveying the process gas, which is introduced into the spray gas channels, along the spray gas channels and spraying it into the processing chamber through the gas discharge holes arranged along the spray gas channels.
